# EUROPÄISCHE PATENTSCHRIFT

(11) **EP 2 761 056 B1**
(45) Veröffentlichungstag und Bekanntmachung des Hinweises auf die Patenterteilung: **27.02.2019**
(21) Anmeldenummer: 12766630.3
(22) Anmeldetag: 21.09.2012
(51) Int. Cl.: C23C 26/00, C23C 28/00, H01L 23/00, H01L 21/00, H01L 25/00, H05K 1/00, H05K 3/00, B23K 35/02, C23C 28/02, H05K 3/34

(54) **SCHICHTVERBUND AUS EINER TRÄGERFOLIE UND EINER SCHICHTANORDNUNG UMFASSEND EINE SINTERBARE SCHICHT AUS MINDESTENS EINEM METALLPULVER UND EINE LOTSCHICHT**
LAYERED COMPOSITE OF A SUBSTRATE FILM AND OF A LAYER ASSEMBLY COMPRISING A SINTERABLE LAYER MADE OF AT LEAST ONE METAL POWDER AND A SOLDER LAYER
ASSEMBLAGE STRATIFIÉ CONSTITUÉ D'UNE FEUILLE SUPPORT ET D'UN ENSEMBLE STRATIFIÉ COMPRENANT UNE COUCHE FRITTABLE CONSTITUÉE D'AU MOINS UNE POUDRE MÉTALLIQUE ET UNE COUCHE DE MÉTAL D'APPORT

(30) Priorität: 30.09.2011 DE 102011083926
(43) Veröffentlichungstag der Anmeldung: 06.08.2014
(73) Patentinhaber: Robert Bosch GmbH, 70442 Stuttgart (DE)
(72) Erfinder: GUYENOT, Michael, 71638 Ludwigsburg (DE); FEIOCK, Andrea, 72124 Pliezhausen (DE); RITTNER, Martin, 71691 Freiburg (DE); FRUEH, Christiane, 71636 Ludwigsburg (DE); KALICH, Thomas, Victoria 3169 (AU); GUENTHER, Michael, 70469 Stuttgart (DE); WETZL, Franz, 74395 Mundelsheim (DE); HOHENBERGER, Bernd, 73240 Wendlingen (DE); HOLZ, Rainer, 71672 Marbach (DE); FIX, Andreas, 70439 Stuttgart (DE)
(86) Internationale Anmeldenummer: PCT/EP2012/068657
(87) Internationale Veröffentlichungsnummer: WO 2013/045364

(56) Entgegenhaltungen:
- EP-A2- 2 193 873
- WO-A2-2005/079353
- DE-A1-102007 048 206
- DE-A1-102008 055 134
- DE-A1-102010 013 610
- DE-A1-102010 038 154
- DE-B3-102004 019 567
- US-A1- 2010 052 162

## Beschreibung

Die Erfindung betrifft einen Schichtverbund zum Verbinden von elektronischen Bauteilen als Fügepartner gemäß dem Gegenstand des Anspruchs 1, ein Verfahren zur Ausbildung eines solchen Schichtverbunds gemäß dem Gegenstand des Anspruchs 8 sowie eine Schaltungsanordnung gemäß dem Gegenstand des Anspruchs 11 und die Verwendung in einem Fügeverfahren gemäß Anspruch 12.

### Stand der Technik

Leistungselektronik wird in vielen Bereichen der Technik eingesetzt. Gerade in elektrischen oder elektronischen Geräten, in welchen große Ströme fließen, ist der Einsatz von Leistungselektronik unumgänglich. Die in der Leistungselektronik notwendigen Stromstärken führen zu einer thermischen Belastung der enthaltenen elektrischen oder elektronischen Komponenten. Eine weitere thermische Belastung ist gegeben durch den Einsatz derartiger elektrischer oder elektronischer Geräte an Betriebsorten mit gegenüber der Raumtemperatur deutlich erhöhter und gegebenenfalls sogar ständig wechselnder Temperatur. Als Beispiele können hierfür Steuergeräte im Automobilbereich genannt werden, welche unmittelbar im Motorraum angeordnet sind.

Insbesondere viele Anbindungen zwischen Leistungshalbleitern beziehungsweise Integrierten Schaltungen (IC, englisch: Integrated Circuit) untereinander sowie an Trägersubstraten, unterliegen schon heute dauerhaften Temperaturbelastungen bis 175 Grad Celsius.

Üblicherweise erfolgt eine Anbindung von elektrischen oder elektronischen Komponenten - beispielsweise auf ein Trägersubstrat - durch eine Verbindungsschicht. Als eine derartige Verbindungsschicht sind Lotverbindungen bekannt.

Zumeist werden Weichlote eingesetzt, welche Zinn-Silber- oder Zinn-Silber-Kupfer-Legierungen basieren. Besonders bei Anwendungstemperaturen nahe der Schmelztemperatur zeigen derartige Verbindungsschichten jedoch schwindende elektrische und mechanische Eigenschaften, die zu einem Ausfall der Baugruppe führen können.

Bleihaltige Lotverbindungen sind bei höheren Einsatztemperaturen einsetzbar als Weichlotverbindungen. Bleihaltige Lotverbindungen sind jedoch durch gesetzliche Bestimmungen aus Gründen des Umweltschutzes hinsichtlich ihrer zulässigen technischen Anwendungen stark beschränkt.

Alternativ bieten sich für den Einsatz bei erhöhten beziehungsweise hohen Temperaturen, insbesondere über 200 Grad Celsius, bleifreie Hartlote an. Bleifreie Hartlote weisen in der Regel einen höheren Schmelzpunkt als 200°C auf. Bei der Verwendung von Hartlot zur Ausbildung einer Verbindungsschicht kommen jedoch nur wenige elektrische oder elektronische Komponenten als Fügepartner in Frage, die den hohen Temperaturen beim Schmelzen der Hartlote standhalten können.

Einen Ausweg zeigt die Niedertemperaturverbindungstechnologie (NTV) auf, bei der silberhaltige Sinterverbindungen bei bereits wesentlich geringeren Temperaturen als der Schmelztemperatur erzeugt werden können. Anstelle eines Lots wird hierbei eine Paste eingesetzt, die chemisch stabilisierte Silberpartikel und/oder Silberverbindungen enthält. Unter den Sinterbedingungen, insbesondere unter Temperatur- und Druckbeaufschlagung, werden dabei die stabilisierenden Bestandteile ausgebrannt und/oder die Silberverbindungen aufgebrochen, so dass die Silberpartikel beziehungsweise freigesetzten Silberatome untereinander und mit dem Material der Fügepartner in direkten Kontakt kommen. Durch Interdiffusion und/oder Diffusion kann dabei bei bereits deutlich geringeren Temperaturen als der Schmelztemperatur eine hochtemperaturstabile Verbindung ausgebildet werden. Eine solche Sinterverbindung wird beispielsweise in der EP 0 242 626 B1 beschrieben. Unter Temperaturwechselbeanspruchung können jedoch bei derartigen Sinterverbindungen thermomechanische Spannungen und sogar eine Rissbildung in Halbleiterbauelementen oder sogar im Trägersubstrat auftreten.

In der Druckschrift DE 10 2010 038 154 A1 wird ein Laminatelektronikbauteil und ein Verfahren zu seiner Herstellung beschrieben.

In der Druckschrift DE 10 2004 019 567 B3 wird ein Verfahren zur Befestigung von elektronischen Bauelementen auf einem Substrat beschrieben.

Vor dem Hintergrund des Standes der Technik besteht weiterhin der Bedarf, insbesondere im Hinblick auf die Verordnungen betreffend das Verbot zur Verwendung von Bleiverbindungen in der Industrie, elektrisch und/oder Wärme leitende Verbindungen bereit zu stellen, die gleichzeitig einen sehr guten Ausgleich der unterschiedlichen Wärmeausdehnungskoeffizienten der Fügepartner auch über einen langen Betriebszeitraum gewährleisten können. Insbesondere bei elektronischen Bauelementen führen darüber hinaus höhere Verlustleistungen und die fortschreitende Miniaturisierung zu einer Steigerung der Einsatztemperaturen insgesamt. Diese steigenden Anforderungen an elektronische Bauelemente sind nur erfüllbar, wenn nicht zuletzt die verwendeten Verbindungstechniken und -materialien hierauf ausgerichtet und in einer weitgehenden Automatisierung verarbeitbar sind.

### Offenbarung der Erfindung

Gegenstand der vorliegenden Erfindung ist ein Schichtverbund zum Verbinden von elektronischen Bauteilen als Fügepartner, umfassend mindestens eine Trägerfolie und eine darauf aufgebrachte Schichtanordnung. Erfindungsgemäß umfasst die Schichtanordnung mindestens eine auf die Trägerfolie aufgebrachte, sinterbare Schicht enthaltend mindestens ein Metallpulver und eine auf die sinterbare Schicht aufgebrachte Lotschicht.

Unter dem Begriff der sinterbaren Schicht kann insbesondere eine Schicht aus einem sinterbaren oder mindestens teilweise bereits gesinterten Material, enthaltend mindestens ein Metallpulver verstanden werden. Insbesondere kann die sinterbare Schicht als bereits vorgeformter, beispielsweise flächig ausgebildeter, folienartiger Formkörper (Sinterfolie) ausgestaltet sein. Ein solcher vorgeformter Formkörper kann auch als Vorkörper (Preform) oder Sinterformkörper bezeichnet werden. Das Material der sinterbaren Schicht kann zur Ausbildung des Vorkörpers getrocknet, angesintert und /oder bereits durchgesintert sein. Ein derartiger Sinterformkörper hat den Vorteil, dass dieser mit einer offenen Porosität ausgebildet sein kann. Bereits integrierte stabile Gaskanäle des Sinterformkörpers können dann der Be- und Entlüftung, einer beispielsweise durch Löten hergestellten Fügeverbindung dienen. Hierdurch kann eine besonders stabile Verbindung mit einem Fügepartner hergestellt und eine Rissbildung beim Fügen weitestgehend vermieden werden, insbesondere wenn großflächige Fügepartner, beispielsweise Silizium-Leistungshalbleiter und Schaltungsträger oder Wärmesenken eingesetzt und miteinander verbunden werden. Die Sinterschicht, insbesondere Sinterformteile, kann weiterhin die Freiheiten beim Design einer Fügeverbindung erweitern, da beispielsweise das Sinterformteil eine größere Fläche als zumindest einer der Fügepartner haben kann und /oder die Fügepartner deutlich weiter voneinander beabstandet werden können, als bei einem direkten Versintern der Fügepartner mittels einer Metallpaste. Die Temperaturwechselbeständigkeit der resultierenden elektronischen Bauteile kann somit erhöht werden.

Als Metallpulver der sinterbaren Schicht können sogenannte Metallflakes oder auch nanoskaliges Metallpulver eingesetzt werden. Zum Beispiel können Silberflakes oder nanoskaliges Silberpulver als Metallpulver verwendet werden. Insbesondere aus Silbermetall gefertigte sinterbare Schichten sind im Hinblick auf die hohe elektrische und thermische Leitfähigkeit von Vorteil. Auch zur Ausbildung einer offenen Porosität im Sinterformkörper ist Silber besonders gut geeignet. Metallflakes sind gewöhnlich kostengünstiger als nanoskalige Metallpulver. Demgegenüber haben nanoskalige Metallpulver gewöhnlich den Vorteil, dass beim Herstellen eines Sinterformkörpers mit deutlich geringerem Prozessdruck gearbeitet werden kann.

Unter Lotschicht wird eine Schicht aus einem Lotmaterial verstanden. Beispielsweise kann das Lotmaterial eine Lotpaste, ein Lotpulver oder ein Lotformkörper sein. Das Lotmaterial kann durch Temperatur- und/oder Druckeinwirkung in eine flüssige Phase übergehen oder Diffusionsverbindungen eingehen und kann sich beispielsweise mit mindestens einem Fügepartner, zum Beispiel mit einem Schaltungsträger, verbinden. Insbesondere können auch bleifreie Lotmaterialien eingesetzt werden. Lotmaterialien können in Aufbauten elektronischer Bauteile zu einer erheblich besseren Entwärmung beitragen als die gewöhnlichen Leitkleber, wobei zusätzlich der Verlust an elektrischer Leistung an der Verbindungsstelle durch den geringeren elektrischen Widerstand niedriger ist.

Elektronische Bauteile als Fügepartner können beispielsweise Halbleiterbauteile, insbesondere Leistungshalbleiterbauteile, Leistungsmodule mit und ohne Logik wie Brückenschaltungen, passive Bauelemente wie Kondensatoren und Widerstände, starre und flexible Schaltungsträger, wie zum Beispiel Leiterplatten, Flexfolie, Keramiksubstrate mit und ohne Metallisierung, Keramik-Metall-Verbundsubstrate wie MMC oder DBC, Stanzgitter, Grundplatten oder Gehäuseteile sowie Kühlkörper sein.

Der erfindungsgemäße Schichtverbund aus einer Trägerfolie und einer auf diese aufgebrachte Schichtanordnung aus Sinterschicht und Lotschicht hat den Vorteil, dass eine einfache und kostengünstige Herstellung von besonders temperaturwechselfesten Fügeverbindungen elektronischer Bauteile ermöglicht wird. Der Schichtverbund kann problemlos in vorhandene Prozesse einer Baugruppenfertigung integriert werden. Man spricht in diesem Zusammenhang auch von guter Inlinefähigkeit. Der damit einhergehende gute Ausgleich der unterschiedlichen Wärmeausdehnungskoeffizienten der Fügepartner kann darüber hinaus auch über einen langen Betriebszeitraum gewährleistet werden. Mit anderen Worten kann mittels des erfindungsgemäßen Schichtverbunds die zerstörende Wirkung von thermo-mechanischen Spannungen, innerhalb eines elektronischen Bauteils, insbesondere während dessen Betriebs, deutlich vermindert werden. Damit kann auch die Standzeit solcher elektronischen Bauteile insgesamt verlängert werden.

Im Rahmen einer Ausführungsform ist das Material der Lotschicht ausgewählt aus der Gruppe SnCu, SnAg, SnAu, SnBi, SnNi, SnZn, Snln, CuNi, CuAg, AgBi, ZnAI, Biln, InAg, InGa, oder ternären oder quarternären Legierung aus einer Mischung daraus. Diese Materialien haben sich für das Fügen von elektronischen Bauteilen als besonders geeignet herausgestellt und zeigen eine gute Kompatibilität zu existierenden Halbleiterbauelementen und eine gute Haftungsfähigkeit auf Metallisierungen. Darüber hinaus sind mit diesen Lotschichten hergestellte Fügeverbindungen besonders temperaturwechselfest und dauerhaft zuverlässig.

Im Rahmen einer weiteren Ausführungsform kann die Lotschicht gebildet werden von einem Reaktionslot, welches aus einer Mischung eines Basislots, beispielsweise aus den oben genannten Lotmaterialien, mit einer AgX-, CuX- oder NiX-Legierung besteht, wobei die Komponente X der AgX-, CuX-, oder NiX-Legierung ausgewählt ist aus der Gruppe bestehend aus B, Mg, AI, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb und Lu und wobei die Schmelztemperatur der AgX-, CuX- oder NiX-Legierung größer ist als die Schmelztemperatur des Basislots.

Dabei sollte die Legierung AgX, CuX, oder NiX insbesondere nicht die gleiche Zusammensetzung wie die des jeweiligen Basislots haben. Das heißt beispielsweise, dass bei einem SnCu-Basislot keine CuSn-Partikel eingemischt sein können.

Vorteilhafterweise kann so eine elektrisch und/oder Wärme leitende Verbindung von elektronischen Bauteilen zu anderen Bauteilen oder Substraten bereit gestellt werden, die gleichzeitig einen sehr guten Ausgleich der unterschiedlichen Wärmeausdehnungskoeffizienten der Fügepartner auch über einen langen Betriebszeitraum gewährleisten kann. Dies kann unter Anderem dadurch erreicht werden, dass das Reaktionslot insbesondere bei einer Temperaturbehandlung die Bildung großer Bereiche einer intermetallischen Phase begünstigt, bis hin zum völligen Ersatz mindestens der Lotschicht durch die gebildeten Bereiche der intermetallischen Phase.

Im Rahmen einer Ausführungsform ist das Basislot ausgewählt aus der Gruppe SnCu, SnAg, SnAu, SnBi, SnNi, SnZn, Snln, CuNi, CuAg, AgBi, ZnAI, Biln, InAg, InGa, oder ternären, quaternären oder einer höherkomponentigen Legierung aus einer Mischung daraus.

Im Rahmen einer weiteren Ausführungsform liegt die AgX-, CuX- oder NiX-Legierung in einer mittleren Partikelgröße zwischen 1 nm und 50 µm in der Mischung mit dem Basislot vor.

Unter der mittleren Partikelgröße kann insbesondere die Größe verstanden werden, bei der 50 Vol.-% der Probe einen kleineren Partikeldurchmesser und 50 Vol.-% der Probe einen größeren Partikeldurchmesser aufweisen (so genannter d₅₀-Wert). Die Bestimmung der Partikelgröße kann zum Beispiel durch Laserstreuung und Auswertung der Streumuster, beispielsweise nach der Mie-Theorie, durch andere optische Analyseverfahren wie beispielsweise Mikroskopie oder durch ein Siebanalyseverfahren ermittelt werden.

Im Rahmen einer weiteren Ausführungsform besteht die sinterbare Schicht aus Silber oder einer Silberlegierung, Kupfer oder einer Kupferlegierung und gegebenenfalls einem Lösungsmittel und/oder einem Additiv. Diese Metalle und Metalllegierungen besitzen eine besonders gute elektrische und thermische Leitfähigkeit. Diese Eigenschaften sind insbesondere für das Fügen von elektronischen Bauteilen günstig im Hinblick auf eine gute Entwärmung und einen geringen Verlust elektrischer Leistung. Darüber hinaus erlauben die genannten metallischen Materialien durch ihre relativ hohen Schmelzpunkte - oder bereiche eine hohe Arbeitstemperatur der gefügten elektronischen Bauteile. Beispielsweise weist Silber einen Schmelzpunkt von 961 °C auf und erlaubt problemlos eine Arbeitstemperatur von 150 °C bis 200 °C und kann auch bei einer Prozesstemperatur von ca. 300°C oder darüber noch eingesetzt werden. Die Metalle und Metalllegierungen, insbesondere Silber und Silberlegierungen, eignen sich darüber hinaus zum Realisieren einer durchgehend offenen, Gaskanäle bildenden Porosität und zeigen in der ausgebildeten sinterbaren Schicht eine gute Benetzbarkeit für alle gängigen Lötmaterialien, wodurch sich diese zum Eingehen einer besonders robusten Lötverbindung eignet.

Als Additiv kann insbesondere ein Additiv eingesetzt werden, das als Redox-Partner dient.

Als Lösungsmittel kann beispielsweise Terpineol, TDA eingesetzt werden.

Im Rahmen einer weiteren Ausführungsform kann die sinterbare Schicht eine Schichtdicke zwischen 5 µm und 300 µm, bevorzugt zwischen 5 µm und 100 µm, besonders bevorzugt zwischen 10 µm und 50 µm, aufweisen.

Die Trägerfolie ist eine Kunststofffolie, insbesondere eine Polyesterfolie, eine Polyethylenterephthalat (PET) -Folie, eine Polyethylen (PE)- oder Polypropylen (PP)-Folie sein. Insbesondere kann die Trägerfolie mit einer Dicke zwischen 10 µm und 200 µm, bevorzugt zwischen 10 µm und 150 µm und besonders bevorzugt zwischen 20 µm und 100 µm, ausgebildet sein. Die Trägerfolien aus den genannten Materialien weisen vorteilhafterweise eine gute Bedruckbarkeit und eine hohe Beständigkeit auf. Die Trägerfolien können mit besonders glatten Oberflächen erzeugt werden. Hierdurch können Hohlräume in der Verbindung mit der sinterbaren Schicht weit möglichst vermindert werden und/oder die sinterbare Schicht kann möglichst Hohlraum-frei (voidfrei) hierauf aufgebracht und/oder erzeugt werden. Auf die Trägerfolien kann vorteilhafterweise eine hohe Zugkraft übertragen werden, wobei diese dabei einen besonders geringen Verzug zeigen. Dies ist insbesondere im Hinblick auf eine Serienfertigung, insbesondere auch in kontinuierlichen Prozessen, günstig. Beispielsweise erlauben diese Eigenschaften der Trägerfolie höhere Verarbeitungsgeschwindigkeiten und die Trägerfolien zeigen ein geringes Risiko von Rissen. In Rolle-zu-Rolle Prozessschritten können die Trägerfolien in längeren Rollen eingesetzt werden, was die Anzahl der notwendigen Rollenwechsel und damit Standzeiten in der laufenden Produktion verringert. Ein weiterer Vorteil ist, dass Trägerfolien aus den genannten Polymermaterialien eine eventuell entstehende elektrostatische Aufladung ableiten können.

Daneben kann auch eine vor dem Aufbringen der sinterbaren Schicht strukturierte Trägerfolie verwendet werden. Auf diese Weise können die sinterbare Schicht und optional auch die weitere Lotschicht ebenfalls strukturiert werden, was im fertigen Bauteil zu einer verbesserten Haftung und einer längeren Lebensdauer der elektrischen Anbindung führen kann.

Im Rahmen einer weiteren Ausführungsform ist die sinterbare Schicht in einer Vielzahl von einzelnen sinterbaren Formteilen mit jeweils darauf angeordneter Lotschicht auf der Trägerfolie angeordnet.

Mit anderen Worten kann auf diese Weise ein Großnutzen zur Verfügung gestellt werden, wie er für eine großtechnische Serienproduktion in der Mikroelektronik benötigt wird. Hierdurch ist es erstmals möglich, eine kontinuierliche oder serielle Fertigung von elektronischen Bauteilen in einem modularen Aufbau auch in Bezug auf die elektrische Anbindung der Bauteile und Substrate zu erreichen. Neben der Inlinefähigkeit der zur Verfügung gestellten einzelnen Formteile mit jeweils darauf aufgebrachter Lotschicht ist außerdem eine vereinfachte Qualitätsüberwachung und die erleichterte Einhaltung von Toleranzen hervorzuheben.

Im Rahmen einer weiteren Ausführungsform ist die sinterbare Schicht zumindest teilweise mit der Lotschicht infiltriert.

Unter dem Begriff "infiltriert" kann insbesondere verstanden werden, dass das Lot mindestens teilweise in den in der sinterbaren Schicht vorhandenen Poren, oder in vergleichbaren Zwischenräumen in der sinterbaren Schicht, angeordnet ist. Durch eine Temperaturbehandlung kann zwischen den Schichten mindestens teilweise eine intermetallische Phase ausgebildet werden. Dieser Vorgang der Ausbildung einer intermetallischen Phase, insbesondere durch Interdiffusion der Metalle bzw. der Legierungen der beiden Schichten, kann durch die vorherige Infiltration des Lots in der sinterbaren Schicht vereinfacht und vervollständigt werden, so dass eine kürzere Temperaturbehandlung beziehungsweise die Ausbildung größerer Bereiche der intermetallischen Phase ermöglicht wird, verglichen mit einer reinen nur angrenzenden Anordnung der Schichten. Mit anderen Worten kann die Schichtanordnung der vorliegenden Erfindung auch in der Weise ausgebildet sein, dass ein Teil der Lotschicht zumindest teilweise, bevorzugt vollständig, in einer porösen oder andere Zwischenräume oder Kammern aufweisenden sinterbaren Schicht infiltriert vorliegt, und der andere Teil der Lotschicht über der sinterbaren Schicht angeordnet ist.

Grundsätzlich ist Bildung von großen Bereichen der intermetallischen Phase weiter begünstigt durch die im Basislot, bevorzugt gleichmäßig verteilt vorliegenden AgX-, CuX- oder NiX-Legierungen. Auf diese Weise sind die Diffusionswege zur Ausbildung einer intermetallischen Phase gering gehalten.

Hinsichtlich weiterer Vorteile und Merkmale wird hiermit explizit auf die Erläuterungen im Zusammenhang mit dem erfindungsgemäßen Verfahren, der erfindungsgemäßen Schaltungsanordnung, der erfindungsgemäßen Verwendung sowie den Figuren verwiesen.

Die Erfindung betrifft weiterhin ein Verfahren zur Ausbildung eines Schichtverbunds der vorstehend in den verschiedenen Ausführungsformen beschriebenen Art, umfassend folgende Schritte:
- Aufbringen einer sinterbaren Schicht enthaltend mindestens ein Metallpulver auf eine Trägerfolie,
- Trocknen der sinterbaren Schicht, und
- Aufbringen einer Lotschicht auf die sinterbare Schicht,
oder
- Aufbringen einer Lotschicht auf eine sinterbare Schicht, insbesondere ein Sinterformteil enthaltend mindestens ein Metallpulver,
- Aufbringen der Schichtanordnung von sinterbarer Schicht und Lotschicht auf eine Trägerfolie.

Mit anderen Worten kann in einer Variante des erfindungsgemäßen Verfahrens zunächst die sinterbare Schicht auf die Trägerfolie aufgebracht und getrocknet werden. Das Aufbringen der sinterbaren Schicht kann zum Beispiel durch ein Druckverfahren, beispielsweise durch Siebdruck, oder durch Dispensen erfolgen. In einem nachfolgenden Schritt kann dann die Lotschicht auf der sinterbaren Schicht, beispielsweise mittels einer Drucktechnik, insbesondere Siebdruck, oder Dispensen aufgebracht werden. Diese Verfahrensvariante hat den Vorteil, dass die sinterbare Schicht bereits durch die Trägerfolie stabilisiert werden kann und so beim nachfolgenden Auftrag der Lotschicht gestützt werden kann.

Alternativ hierzu kann zunächst die die Schichtanordnung hergestellt werden. Hierbei wird die sinterbare Schicht, beispielsweise als Sinterformteil, insbesondere Sinterfolie, bereitgestellt und die Lotpaste hierauf aufgebracht, beispielsweise mittels Siebdruck oder Dispensen. Dann wird nachfolgend die Schichtanordnung aus sinterbarer Schicht und Lotschicht auf eine Trägerfolie aufgebracht. Diese Verfahrensvariante hat den Vorteil, dass beispielsweise durch optische Prüfung fehlerhafte Schichtanordnungen bereits vor der Aufbringung auf die Trägerfolie aussortiert und so die Anzahl der Ausfälle durch mangelhafte Fügeverbindungen in den elektronischen Bauteilen als Endprodukten vermindert werden kann.

Im Rahmen einer Ausgestaltung des Verfahrens kann das Trocknen der sinterbaren Schicht bei einer Temperatur zwischen 50 °C und 200 °C, insbesondere zwischen 100 °C und 175 °C, oder mit einer Ansinterung bis 325 °C, durchgeführt werden. Die Ansinterung kann wahlweise auch vor oder nach dem Trocknen durchgeführt werden.

Im Rahmen einer weiteren Ausgestaltung des Verfahrens kann die sinterbare Schicht vor oder nach dem Aufbringen auf die Trägerfolie in eine Vielzahl von einzelnen sinterbaren Formteilen geteilt werden.

Hinsichtlich weiterer Vorteile und Merkmale wird hiermit explizit auf die Erläuterungen im Zusammenhang mit dem erfindungsgemäßen Schichtverbund, der erfindungsgemäßen Schaltungsanordnung, der erfindungsgemäßen Verwendung sowie den Figuren verwiesen.

Die Erfindung betrifft weiterhin eine Schaltungsanordnung enthaltend einen Schichtverbund gemäß einer der vorstehend beschriebenen Ausgestaltungen der Erfindung oder gemäß einer Kombination verschiedener vorgenannter Ausgestaltungen, insbesondere für elektronische Schaltungsanordnungen für die Automobilserienproduktion.

Hinsichtlich weiterer Vorteile und Merkmale wird hiermit explizit auf die Erläuterungen im Zusammenhang mit dem erfindungsgemäßen Schichtverbund, dem erfindungsgemäßen Verfahren, der erfindungsgemäßen Verwendung sowie den Figuren verwiesen.

Die Erfindung betrifft weiterhin die Verwendung eines erfindungsgemäßen Schichtverbunds entsprechend einer der vorstehend beschriebenen Ausgestaltungen der Erfindung oder entsprechend einer Kombination verschiedener vorgenannter Ausgestaltungen in einem Fügeverfahren für elektronische Bauteile umfassend die Schritte:
- Aufbringen des Schichtverbunds auf mindestens ein elektronisches Bauteil,
- Herstellen einer Haftung zwischen dem mindestens einen Bauteil und der Schichtanordnung mittels Erwärmen und/oder mittels Druckbeaufschlagung,
- Abheben des mindestens einen Bauteils mit der daran haftenden Schichtanordnung von der Trägerfolie,
- Aufbringen der dem anhaftenden Bauteil gegenüberliegenden Seite der Schichtanordnung auf den Fügepartner,
- Herstellen einer Haftung zwischen dem Fügepartner und der Schichtanordnung sowie optional Erhöhung der Haftung zwischen dem Bauteil und der Schichtanordnung mittels Temperaturbehandlung und/oder Druckbeaufschlagung.

Zur Herstellung einer Fügeverbindung zwischen beispielsweise einem elektronischen Leistungsbauteil und einem Substrat wird auf den erfindungsgemäß ausgebildeten Schichtverbund mit Trägerfolie zunächst das Leistungsbauteil auf die Lotschicht aufgesetzt. Zur Herstellung der Haftung zwischen dem Schichtverbund aus Lotschicht und sinterbaren Schicht und dem Leistungsbauteil wird der lose Verbund mit einem Druck, zum Beispiel zwischen 20 MPa und 80 MPa, und/oder mit einer Temperatur, zum Beispiel zwischen 40°C und 80°C, beaufschlagt. Insgesamt wird eine solche Haftung zwischen dem Schichtverbund und dem Bauteil angestrebt, die größer ist als die Haftung zwischen der Trägerfolie und dem Verbund, so dass die Trägerfolie ohne Delamination des Bauteils entfernbar ist. Nach dem Abheben von der Trägerfolie, beispielsweise durch eine Abnahmevorrichtung wie sie in der Serienfertigung als "Pic-and-Place-Automat" bekannt ist, kann der Verbund aus Schichtanordnung und Bauteil nunmehr auf den Fügepartner, beispielsweise ein Substrat, aufgesetzt werden. Das Substrat kann dabei auf der zu fügenden Oberfläche optional ebenfalls mit einer sinterbaren Schicht oder mit einer Lotschicht versehen sein. In einem abschließenden Verfahrensschritt wird die Haftung zwischen dem Substrat und dem Verbund mit dem Bauteil durch Beaufschlagung mit Druck und/oder Temperatur hergestellt. Hierbei können sich intermetallische Phasen zwischen der Bauteiloberfläche, der Lotschicht, der sinterbaren Schicht und der Substratoberfläche ausbilden, die eine hochtemperaturfeste und mechanisch stabile elektrische Anbindung mit hervorragenden Leitfähigkeits- und Ausgleichseigenschaften in Bezug auf die stark unterschiedlichen Wärmeausdehnungskoeffizienten der beiden zu fügenden Elemente ermöglichen.

Das ist besonders vorteilhaft für die Temperaturwechsellastfestigkeit sowie die kritische Sperrschichttemperatur von Hochleistungsprodukten, in denen der erfindungsgemäße Schichtverbund zur Verbindung von Fügepartnern, insbesondere elektronischen Bauteilen, eingesetzt wurde.

Hinsichtlich weiterer Vorteile und Merkmale wird hiermit explizit auf die Erläuterungen im Zusammenhang mit dem erfindungsgemäßen Schichtverbund, dem erfindungsgemäßen Verfahren, der erfindungsgemäßen Schaltungsanordnung sowie den Figuren verwiesen.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen
- Fig. 1: einen schematischen Querschnitt durch eine Ausführungsform eines erfindungsgemäßen Schichtverbunds.
- Fig. 2: einen schematischen Querschnitt durch eine zweite Ausführungsform eines erfindungsgemäßen Schichtverbunds.

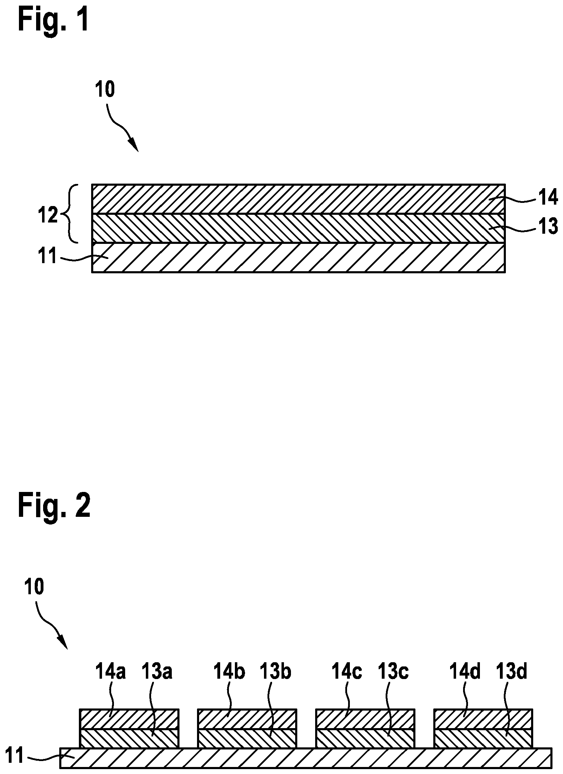

Die Figur 1 zeigt einen Schichtverbund 10 umfassend mindestens eine Trägerfolie 11 und eine darauf aufgebrachte Schichtanordnung 12. Die Trägerfolie kann eine Kunststofffolie, insbesondere eine Polyesterfolie sein. Erfindungsgemäß umfasst die Schichtanordnung 12 mindestens eine auf die Trägerfolie 11 aufgebrachte, sinterbare Schicht 13 enthaltend mindestens ein Metallpulver und eine auf die sinterbare Schicht aufgebrachte Lotschicht 14. Die sinterbare Schicht 13 ist aus Silber oder einer Silberlegierung, Kupfer oder einer Kupferlegierung und gegebenenfalls einem Lösungsmittel. Gegebenenfalls kann zusätzlich ein Additiv eingesetzt werden, das insbesondere als Redox-Partner dienen kann. Das Material der Lotschicht 14 ist ausgewählt aus der Gruppe SnCu, SnAg, SnAu, SnBi, SnNi, SnZn, Snln, CuNi, CuAg, AgBi, ZnAI, Biln, InAg, InGa, oder ternären oder quarternären Legierung aus einer Mischung daraus und ist bevorzugt bleifrei. Der Schichtverbund 10 kann insbesondere zum Verbinden von elektronischen Bauteilen als Fügepartner verwendet werden.

Die Figur 2 zeigt eine Ausführungsform eines erfindungsgemäßen Schichtverbunds, in der die sinterbare Schicht 13 in einer Vielzahl von einzelnen sinterbaren Formteilen 13a, 13b, 13c, 13d mit jeweils darauf angeordneter Lotschicht 14a, 14b, 14c, 14d auf der Trägerfolie 11 angeordnet ist. Nur zum Zweck der Übersichtlichkeit sind lediglich vier der sinterbaren Formteile (13a, 13b, 13c, 13d) mit darauf aufgebrachter Lotschicht 14a, 14b, 14c, 14d gezeigt. Es ist selbstverständlich möglich deutlich mehr dieser sinterbaren Formteile auf der Trägerfolie 11 anzuordnen und diese gemeinsam zu prozessieren. Die Herstellung des Schichtverbunds kann besonders kostengünstig und mit hoher Fertigungskapazität erfolgen und kann darüber hinaus problemlos in vorhandene Prozesse einer Baugruppenfertigung integriert werden. Man spricht in diesem Zusammenhang auch von guter Inlinefähigkeit. Dies ist insbesondere für eine Serienfertigung von elektronischen Baugruppen vorteilhaft.

## Patentansprüche

1. Schichtverbund (10) zum Verbinden von elektronischen Bauteilen als Fügepartner, umfassend mindestens eine Trägerfolie (11) und eine darauf aufgebrachte Schichtanordnung (12) umfassend mindestens eine auf die Trägerfolie (11) aufgebrachte, sinterbare Schicht (13) enthaltend mindestens ein Metallpulver und eine auf die sinterbare Schicht (13) aufgebrachte Lotschicht (14), wobei die Trägerfolie (11) eine Kunststofffolie, insbesondere eine Polyersterfolie, eine PET-Folie, eine PE- oder PP-Folie, insbesondere mit einer Dicke zwischen 10 µm und 200 µm, bevorzugt zwischen 10 µm und 150 µm und besonders bevorzugt zwischen 20 µm und 100 µm, ist.

2. Schichtverbund nach Anspruch 1 **dadurch gekennzeichnet, dass** das Material der Lotschicht (14) ausgewählt ist aus der Gruppe SnCu, SnAg, SnAu, SnBi, SnNi, SnZn, Snln, CuNi, CuAg, AgBi, ZnAI, Biln, InAg, InGa, oder ternären oder quarternären Legierung aus einer Mischung daraus.

3. Schichtverbund nach Anspruch 1 oder 2 **dadurch gekennzeichnet, dass** die Lotschicht (14) gebildet wird von einem Reaktionslot, welches aus einer Mischung eines Basislots mit einer AgX-, CuX- oder NiX-Legierung besteht, wobei das Basislot ausgewählt ist aus der Gruppe SnCu, SnAg, SnAu, SnBi, SnNi, SnZn, Snln, CuNi, CuAg, AgBi, ZnAI, Biln, InAg, InGa oder ternären, quaternären oder einer höherkomponentigen Legierung aus einer Mischung daraus, wobei die Komponente X der AgX-, CuX-, oder NiX-Legierung ausgewählt ist aus der Gruppe bestehend aus B, Mg, AI, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb und Lu, wobei die Legierung AgX, CuX oder NiX nicht die gleiche Zusammensetzung wie die des jeweiligen Basislots aufweist und wobei die Schmelztemperatur der AgX-, CuX- oder NiX-Legierung größer ist als die Schmelztemperatur des Basislots.

4. Schichtverbund nach einem der Ansprüche 1, 2 oder 3, **dadurch gekennzeichnet, dass** die sinterbare Schicht (13) aus Silber oder einer Silberlegierung, Kupfer oder einer Kupferlegierung und einem Lösungsmittel besteht.

5. Schichtverbund nach einem der vorherigen Ansprüche, **dadurch gekennzeichnet, dass** die sinterbare Schicht (13) eine Schichtdicke zwischen 5 µm und 300 µm, bevorzugt zwischen 5 µm und 100 µm, besonders bevorzugt zwischen 10 µm und 50 µm, aufweist.

6. Schichtverbund nach einem der vorherigen Ansprüche, **dadurch gekennzeichnet, dass** die sinterbare Schicht (13) in einer Vielzahl von einzelnen sinterbaren Formteilen (13a, 13b, 13c, 13d ....) mit jeweils darauf angeordneter Lotschicht (14a, 14b, 14c, 14d, ...) auf der Trägerfolie angeordnet ist.

7. Schichtverbund nach einem der vorherigen Ansprüche, **dadurch gekennzeichnet, dass** die sinterbare Schicht (13) zumindest teilweise mit der Lotschicht (14) infiltriert ist.

8. Verfahren zur Ausbildung eines Schichtverbunds (10) nach einem der vorherigen Ansprüche 1 bis 7, umfassend folgende Schritte:
- Aufbringen einer sinterbaren Schicht (13) enthaltend mindestens ein Metallpulver auf eine Trägerfolie (11),
- Trocknen der sinterbaren Schicht (13), und
- Aufbringen einer Lotschicht (14) auf die sinterbare Schicht (13), oder
- Aufbringen einer Lotschicht (14) auf eine sinterbare Schicht (13) enthaltend mindestens ein Metallpulver, und
- Aufbringen der Schichtanordnung von sinterbarer Schicht (13) und Lotschicht (14) auf eine Trägerfolie,
- und wobei im Verfahren die Trägerfolie (11) eine Kunststofffolie, insbesondere eine Polyersterfolie, eine PET-Folie, eine PE- oder PP-Folie, insbesondere mit einer Dicke zwischen 10 µm und 200 µm, bevorzugt zwischen 10 µm und 150 µm und besonders bevorzugt zwischen 20 µm und 100 µm.

9. Verfahren nach Anspruch 8, **dadurch gekennzeichnet, dass** das Trocknen bei einer Temperatur zwischen 50 °C und 200 °C, insbesondere zwischen 100 °C und 175 °C, oder mit einer Ansinterung bis 325 °C, durchgeführt wird.

10. Verfahren nach Anspruch 8 oder 9, **dadurch gekennzeichnet, dass** die sinterbare Schicht (13) vor oder nach dem Aufbringen auf die Trägerfolie in eine Vielzahl von einzelnen sinterbaren Formteilen (13a, 13b, 13c, 13d ....) geteilt wird.

11. Schaltungsanordnung enthaltend einen Schichtverbund (10) gemäß einem der Ansprüche 1 bis 7, insbesondere für elektronische Schaltungsanordnungen für die Automobilserienproduktion.

12. Verwendung eines Schichtverbunds (10) gemäß einem der Ansprüche 1 bis 7 in einem Fügeverfahren für elektronische Bauteile umfassend die Schritte:
- Aufbringen eines Schichtverbunds (10) auf mindestens ein elektronisches Bauteil,
- Herstellen einer Haftung zwischen dem mindestens einen Bauteil und der Schichtanordnung (12) mittels Erwärmen oder mittels Druckbeaufschlagung,
- Abheben des mindestens einen Bauteils mit der daran haftenden Schichtanordnung (12) von der Trägerfolie (11),
- Aufbringen der dem anhaftenden Bauteil gegenüberliegenden Seite der Schichtanordnung (12) auf den Fügepartner,
- Herstellen einer Haftung zwischen dem Fügepartner und der Schichtanordnung (12) sowie optional Erhöhung der Haftung zwischen dem Bauteil und der Schichtanordnung (12) mittels Temperaturbehandlung und/oder Druckbeaufschlagung.

## Claims

1. Layer composite (10) for joining electronic components as join partners, which comprises at least one support film (11) and a layer arrangement (12) applied thereto comprising at least one sinterable layer (13) which has been applied to the support film (11) and contains at least one metal powder and a solder layer (14) applied to the sinterable layer (13), wherein the support film (11) is a polymer film, in particular a polyester film, a PET film, a PE or PP film, in particular having a thickness in the range from 10 µm to 200 pm, preferably from 10 µm to 150 µm and particularly preferably from 20 µm to 100 µm.

2. Layer composite according to Claim 1, **characterized in that** the material of the solder layer (14) is selected from the group consisting of SnCu, SnAg, SnAu, SnBi, SnNi, SnZn, SnIn, CuNi, CuAg, AgBi, ZnAl, BiIn, InAg, InGa and ternary or quaternary alloys of a mixture thereof.

3. Layer composite according to Claim 1 or 2, **characterized in that** the solder layer (14) is formed by a reactive solder consisting of a mixture of a base solder with an AgX, CuX or NiX alloy, where the base solder is selected from the group consisting of SnCu, SnAg, SnAu, SnBi, SnNi, SnZn, SnIn, CuNi, CuAg, AgBi, ZnAl, BiIn, InAg, InGa and ternary, quaternary or more-component alloys of mixtures thereof, where the component X of the AgX, CuX or NiX alloy is selected from the group consisting of B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb and Lu, where the alloy AgX, CuX or NiX does not have the same composition as the respective base solder and where the melting point of the AgX, CuX or NiX alloy is greater than the melting point of the base solder.

4. Layer composite according to any of Claims 1, 2 and 3, **characterized in that** the sinterable layer (13) consists of silver or a silver alloy, copper or a copper alloy and a solvent.

5. Layer composite according to any of the preceding claims, **characterized in that** the sinterable layer (13) has a layer thickness in the range from 5 µm to 300 µm, preferably from 5 µm to 100 µm, particularly preferably from 10 µm to 50 µm.

6. Layer composite according to any of the preceding claims, **characterized in that** the sinterable layer (13) is arranged in a plurality of individual sinterable shaped parts (13a, 13b, 13c, 13d ...), with solder layer (14a, 14b, 14c, 14d ...) applied thereto in each case, on the support film.

7. Layer composite according to any of the preceding claims, **characterized in that** the sinterable layer (13) is at least partly infiltrated with the solder layer (14).

8. Process for forming a layer composite (10) according to any of Claims 1 to 7, which comprises the following steps:
- application of a sinterable layer (13) containing at least one metal powder to a support film (11),
- drying of the sinterable layer (13), and
- application of a solder layer (14) to the sinterable layer (13), or
- application of a solder layer (14) to a sinterable layer (13) containing at least one metal powder, and
- application of the layer arrangement of sinterable layer (13) and solder layer (14) to a support film,
- and wherein, in the process, the support film (11) is a polymer film, in particular a polyester film, a PET film, a PE or PP film, in particular having a thickness in the range from 10 µm to 200 µm, preferably from 10 µm to 150 µm and particularly preferably from 20 µm to 100 µm.

9. Process according to Claim 8, **characterized in that** drying is carried out at a temperature in the range from 50°C to 200°C, in particular from 100°C to 175°C, or with partial sintering up to 325°C.

10. Process according to Claim 8 or 9, **characterized in that** the sinterable layer (13) is divided into a plurality of individual sinterable shaped parts (13a, 13b, 13c, 13d ...) before or after application to the support film.

11. Circuit arrangement comprising a layer composite (10) according to any of Claims 1 to 7, in particular for electronic circuit arrangements for automobile mass production.

12. Use of a layer composite (10) according to any of Claims 1 to 7 in a joining process for electronic components, which comprises the steps:
- application of a layer composite (10) to at least one electronic component,
- establishment of adhesion between the at least one component and the layer arrangement (12) by means of heating or by application of pressure,
- lifting of the at least one component together with the layer arrangement (12) adhering thereto from the support film (11),
- application of the side of the layer arrangement (12) opposite the adhering component to a join partner,
- establishment of adhesion between the join partner and the layer arrangement (12) and also optionally effecting an increase in the adhesion between the component (15) and the layer arrangement (12) by means of heat treatment and/or application of pressure.

## Revendications

1. Composite stratifié (10) pour la liaison de composants électroniques en tant que partenaires d'assemblage, comprenant au moins une feuille support (11) et un agencement stratifié (12) appliqué sur celle-ci, comprenant au moins une couche frittable (13) appliquée sur la feuille support (11), contenant au moins une poudre métallique, et une couche de métal d'apport (14) appliquée sur la couche frittable (13), la feuille support (11) étant une feuille en matière plastique, notamment une feuille en polyester, une feuille en PET, une feuille en PE ou PP, notamment d'une épaisseur comprise entre 10 µm et 200 µm, de préférence entre 10 µm et 150 µm, et de manière particulièrement préférée entre 20 µm et 100 µm.

2. Composite stratifié selon la revendication 1, **caractérisé en ce que** le matériau de la couche de métal d'apport (14) est choisi dans le groupe constitué par SnCu, SnAg, SnAu, SnBi, SnNi, SnZn, SnIn, CuNi, CuAg, AgBi, ZnAl, BiIn, InAg, InGa, ou un alliage ternaire ou quaternaire constitué par un mélange de ceux-ci.

3. Composite stratifié selon la revendication 1 ou 2, **caractérisé en ce que** la couche de métal d'apport (14) est formée par un métal d'apport de réaction, qui est constitué par un mélange d'un métal d'apport de base avec un alliage AgX, CuX ou NiX, le métal d'apport de base étant choisi dans le groupe constitué par SnCu, SnAg, SnAu, SnBi, SnNi, SnZn, SnIn, CuNi, CuAg, AgBi, ZnAl, BiIn, InAg, InGa ou un alliage ternaire, quaternaire ou contenant un nombre supérieur de composants, constitué par un mélange de ceux-ci, le composant X de l'alliage AgX, CuX ou NiX étant choisi dans le groupe constitué par B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb et Lu, l'alliage AgX, CuX ou NiX ne présentant pas la même composition que celle du métal d'apport de base respectif, et la température de fusion de l'alliage AgX, CuX ou NiX étant supérieure à la température de fusion du métal d'apport de base.

4. Composite stratifié selon l'une quelconque des revendications 1, 2 ou 3, **caractérisé en ce que** la couche frittable (13) est constituée par de l'argent ou un alliage d'argent, du cuivre ou un alliage de cuivre et un solvant.

5. Composite stratifié selon l'une quelconque des revendications précédentes, **caractérisé en ce que** la couche frittable (13) présente une épaisseur de couche comprise entre 5 µm et 300 µm, de préférence entre 5 µm et 100 µm, de manière particulièrement préférée entre 10 µm et 50 pm.

6. Composite stratifié selon l'une quelconque des revendications précédentes, **caractérisé en ce que** la couche frittable (13) est agencée sur la feuille support en une pluralité de pièces moulées frittables individuelles (13a, 13b, 13c, 13d...) avec à chaque fois une couche de métal d'apport (14a, 14b, 14c, 14d...) agencée au-dessus.

7. Composite stratifié selon l'une quelconque des revendications précédentes, **caractérisé en ce que** la couche frittable (13) est au moins partiellement infiltrée avec la couche de métal d'apport (14).

8. Procédé de formation d'un composite stratifié (10) selon l'une quelconque des revendications 1 à 7 précédentes, comprenant les étapes suivantes :
- l'application d'une couche frittable (13) contenant au moins une poudre métallique sur une feuille support (11),
- le séchage de la couche frittable (13), et
- l'application d'une couche de métal d'apport (14) sur la couche frittable (13), ou
- l'application d'une couche de métal d'apport (14) sur la couche frittable (13) contenant au moins une poudre métallique, et
- l'application de l'agencement stratifié de la couche frittable (13) et de la couche de métal d'apport (14) sur une feuille support,
- la feuille support (11) dans le procédé étant une feuille en matière plastique, notamment une feuille en polyester, une feuille en PET, une feuille en PE ou PP, notamment d'une épaisseur comprise entre 10 µm et 200 µm, de préférence entre 10 µm et 150 µm, et de manière particulièrement préférée entre 20 µm et 100 µm.

9. Procédé selon la revendication 8, **caractérisé en ce que** le séchage est réalisé à une température comprise entre 50 °C et 200 °C, notamment entre 100 °C et 175 °C, ou avec un frittage jusqu'à 325 °C.

10. Procédé selon la revendication 8 ou 9, **caractérisé en ce que** la couche frittable (13) est divisée avant ou après l'application sur la feuille support en une pluralité de pièce moulées frittables individuelles (13a, 13b, 13c, 13d...) .

11. Circuit, contenant un composite stratifié (10) selon l'une quelconque des revendications 1 à 7, notamment pour circuits électroniques pour la production en série d'automobiles.

12. Utilisation d'un composite stratifié (10) selon l'une quelconque des revendications 1 à 7 dans un procédé d'assemblage pour composants électroniques, comprenant les étapes suivantes :
- l'application d'un composite stratifié (10) sur au moins un composant électronique,
- la création d'une adhésion entre ledit au moins un composant et l'agencement stratifié (12) par chauffage ou par application d'une pression,
- le décollement dudit au moins un composant avec l'agencement stratifié (12) collé sur celui-ci de la feuille support (11),
- l'application du côté de l'agencement stratifié (12) opposé au composant collé sur le partenaire d'assemblage,
- la création d'une adhésion entre le partenaire d'assemblage et l'agencement stratifié (12), et éventuellement l'augmentation de l'adhésion entre le composant et l'agencement stratifié (12) par traitement thermique et/ou application d'une pression.
